(19) Europäisches Patentamt / European Patent Office / Office européen des brevets

(11) **EP 4 636 420 A1**

(12) **EUROPEAN PATENT APPLICATION**
published in accordance with Art. 153(4) EPC

(43) Date of publication:
**22.10.2025   Bulletin 2025/43**

(21) Application number: **23903175.0**

(22) Date of filing: **13.11.2023**

(51) International Patent Classification (IPC):
*G01R 31/388* (2019.01)     *G01R 31/382* (2019.01)
*G01R 31/3828* (2019.01)     *G01R 31/387* (2019.01)
*G01R 31/392* (2019.01)     *H01M 10/48* (2006.01)
*H02J 7/00* (2006.01)

(52) Cooperative Patent Classification (CPC):
**G01R 31/382; G01R 31/3828; G01R 31/385;
G01R 31/387; G01R 31/388; G01R 31/392;
H01M 10/48; H02J 7/00; Y02E 60/10**

(86) International application number:
**PCT/JP2023/040731**

(87) International publication number:
**WO 2024/127877 (20.06.2024 Gazette 2024/25)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority:  **12.12.2022  JP 2022198097**

(71) Applicant: **DENSO CORPORATION**
**Kariya-city, Aichi 448-8661 (JP)**

(72) Inventors:
• **UCHIYAMA, Masaki**
  **Kariya- city, Aichi 4488661 (JP)**
• **KUBO, Shunichi**
  **Kariya- city, Aichi 4488661 (JP)**

(74) Representative: **TBK**
**Bavariaring 4-6**
**80336 München (DE)**

(54) **REMAINING CAPACITY CALCULATION DEVICE AND PROGRAM**

(57)    A remaining capacity calculation device (30) calculates a remaining capacity of a storage cell (21) when the storage cell is charged and discharged. The remaining capacity calculation device includes a first region calculation unit that calculates, at a detection timing of an open circuit voltage of the storage cell, a reference remaining capacity of the storage cell based on a correlation between the open circuit voltage and the remaining capacity of the storage cell, and calculates, as a first capacity region, a predetermined region including the reference remaining capacity; a second region calculation unit that calculates a second capacity region by, to a maximum remaining capacity and a minimum remaining capacity in a past capacity region calculated at the detection timing before a present time, adding a change of capacity, which is a change of a current capacity due to charge and discharge of the storage cell from time at which the past capacity region was calculated; and a third region calculation unit that calculates, at the detection timing, a region including an overlapped region between the first capacity region and the second capacity region, as a third capacity region including an actual remaining capacity.

FIG.1

**Description**

[Cross-Reference to Related Application]

The present application is based on and claims the benefit of priority from earlier Japanese Patent Application No. 2022-198097 filed on December 12, 2022, the description of which is incorporated herein by reference.

[Technical Field]

The present disclosure relates to a remaining capacity calculation device and a program.

[Background Art]

Conventionally, devices calculating a remaining capacity of a storage battery have been known. For example, PTL 1 describes a technique for calculating SOC of a storage battery using a SOC-OCV map indicating a correlation between SOC (State Of Charge) and an open circuit voltage.

[Citation List]

[Patent Literature]

[PTL 1] JP 2010-266221 A

[Summary of the Invention]

In some cases, it is difficult to calculate a remaining capacity of a storage battery with high accuracy. For example, in a plateau region in a correlation between an open circuit voltage and a remaining capacity of a storage battery, since change of the open circuit voltage with change of the remaining capacity is small, it is difficult to calculate the remaining capacity with high accuracy based on the open circuit voltage. In addition, for example, when charging/discharging currents of a storage battery are integrated to calculate a remaining capacity, since integrated errors are accumulated as a current integrating period is prolonged, it is difficult to calculate the remaining capacity with high accuracy based on an integrated current value.

The present disclosure has a main object of providing a remaining capacity calculation device and a program that can improve accuracy in calculating a remaining capacity of a storage cell.

The present disclosure is a remaining capacity calculation device that calculates a remaining capacity of a storage cell when the storage cell is charged and discharged, the device including:

a first region calculation unit that calculates, at a detection timing of an open circuit voltage of the storage cell, a reference remaining capacity of the storage cell based on a correlation between the open circuit voltage and the remaining capacity of the storage cell, and calculates, as a first capacity region, a predetermined region including the reference remaining capacity;

a second region calculation unit that calculates a second capacity region by, to a maximum remaining capacitiy and a minimum remaining capacitiy in a past capacity region calculated at the detection timing before a present time, adding a change of capacity, which is a change of a current capacity due to charge and discharge of the storage cell from the time at which the past capacity region was calculated; and

a third region calculation unit that calculates, at the detection timing, a region including an overlapped region between the first capacity region and the second capacity region, as a third capacity region including an actual remaining capacity.

At the detection timing of the open circuit voltage of the storage cell, the reference remaining capacity of the storage cell is calculated based on the correlation between the open circuit voltage and the remaining capacity of the storage cell, and the first capacity region is calculated as a predetermined region including the reference remaining capacity. In addition, to the maximum remaining capacitiy and the minimum remaining capacitiy in a past capacity region calculated at the detection timing of the open circuit voltage of the storage cell before the present time, change of capacity, which is a change of the current capacity due to charge and discharge of the storage cell from the time at which the past capacity region was calculated is added, to calculate the second capacity region. In this case, the first capacity region is calculated considering variation of the remaining capacities occurring under a condition for detecting the open circuit voltage of the storage cell and a condition for charging and discharging the storage cell, the second capacity region is calculated considering integrated errors of the integrated value of the current capacities, and a region including an overlapped region between the capacity regions is calculated as the third capacity region. Hence, the range of the third capacity region including an actual remaining capacity of the storage cell can be specified. Since the range of the third capacity region is specified, accuracy in calculating the remaining capacity of the storage cell can be improved.

[Brief Description of the Drawings]

The above-mentioned and other objects, features and advantages of the present disclosure will become more apparent by reference to the following detailed description taken in conjunction with the accompanying drawings, in which

[FIG. 1] FIG. 1 is a drawing illustrating a schematic configuration of a battery system according to a first embodiment;
[FIG. 2] FIG. 2 is a drawing illustrating a method of setting a first capacity region;
[FIG. 3] FIG. 3 is a drawing illustrating a method of setting a second capacity region;
[FIG. 4] FIG. 4 is a drawing illustrating a method of setting a third capacity region;
[FIG. 5] FIG. 5 is a flowchart illustrating a procedure of control performed by a BMU;
[FIG. 6] FIG. 6 is a drawing illustrating an example of control for calculating a full charging capacity;
[FIG. 7] FIG. 7 is a flowchart illustrating a procedure of control performed by a BMU according to a second embodiment; and
[FIG. 8] FIG. 8 is a drawing illustrating an example of control for calculating a full charging capacity.

[Description of the Embodiments]

<First embodiment>

Hereinafter, a first embodiment embodying a remaining capacity calculation device according to the present disclosure will be described with reference to the drawings. In the present embodiment, a specific configuration of a battery system mounted to an electric motor vehicle such as an electric automobile, a hybrid automobile, or the like will be described.

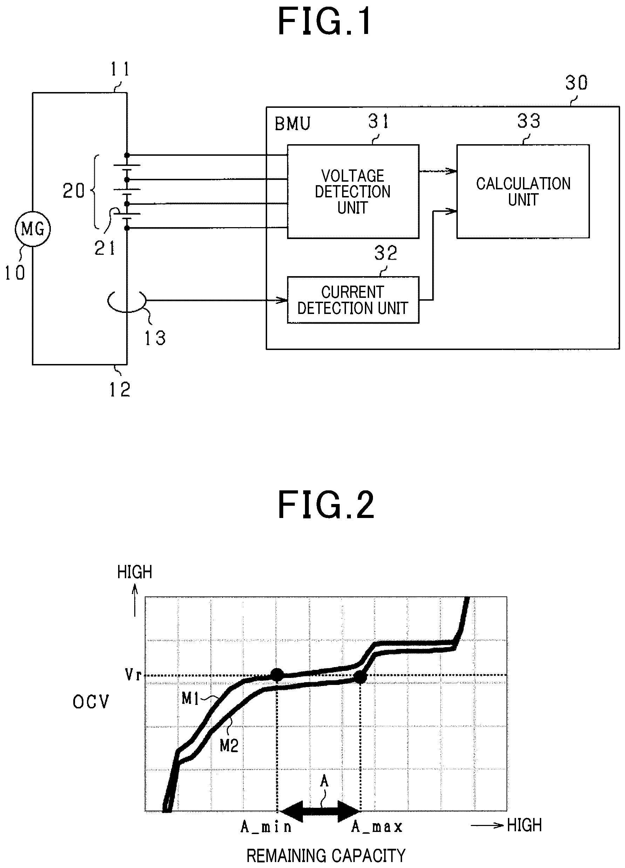

FIG. 1 is a drawing illustrating a schematic configuration of a battery system according to the present embodiment. The battery system includes a rotary electric machine 10, which is a propulsion power source of a vehicle, an assembled battery 20 consisting of a plurality of cells 21, and a BMU (Battery Management Unit) 30 monitoring a state of the assembled battery 20.

The assembled battery 20 is used as a power source of the rotary electric machine 10 and is connected to the rotary electric machine 10. Specifically, the rotary electric machine 10 has an inverter controlling currents of respective phases. The assembled battery 20 is configured as a series connection of the plurality of cells 21. A positive-electrode side power line 11 extending from a terminal of the serially connected cells 21 located at the most positive-electrode side is connected to a positive-electrode side of the inverter. A negative-electrode side power line 12 extending from a terminal of the serially connected cells 21 located at the most negative-electrode side is connected to a negative-electrode side of the inverter. Hence, energization can be performed between the assembled battery 20 and the rotary electric machine 10. Each of the cells 21 is a chargeable and dischargeable storage battery, specifically, a lithium-ion battery.

The BMU 30 is configured by a microcomputer including a CPU and various memories. The BMU 30 includes a voltage detection unit 31, a current detection unit 32, and a calculation unit 33. The voltage detection unit 31 is connected to both terminals of each of the cells 21 via wirings such as wire a wire harness and detects a terminal voltage of each of the cells 21. In the present embodiment, when the vehicle starts traveling or is externally charged, the voltage detection unit 31 detects an open circuit voltage, which is a voltage between the terminals of the cell 12 in a case in which no load is applied to the cells 21 and the cells 21 are in a non-energization state. For example, when the vehicle starts traveling, the voltage detection unit 31 detects an open circuit voltage of the cell 21 at the timing before an ignition switch is turned on and energization of the cells 21 is started. In addition, when the vehicle is externally charged, the voltage detection unit 31 detects an open circuit voltage of the cell 21 at the timing before energization to the assembled battery 20 is started using an external charger provided outside the vehicle.

The current detection unit 32 detects a charge/discharge current of the assembled battery 20 at predetermined time interval. In FIG. 1, the current detection unit 32 acquires a detection single of a current sensor 13 provided on the negative-electrode side power line 12 to detect a charge/discharge current of the assembled battery 20 based on the detection single. A detection value of the voltage detection unit 31 and a detection value of the current detection unit 32 are input to the calculation unit 33.

When the cells 21 configuring the assembled battery 20 are charged or discharged, the calculation unit 33 sequentially calculates remaining capacities of each of the cells 21. In the present embodiment, as the remaining capacity of the cell 21, the calculation unit 33 calculates a current capacity [Ah]. It is noted that the calculation unit 33 may calculate, as the remaining capacity of the cell 21, a power capacity [Wh] or a SOC [%] instead of the current capacity [Ah].

Incidentally, there is a case in which it is difficult to calculate a remaining capacity of the cell 21 with high accuracy. Specifically, in a correlation between the open circuit voltage and the remaining capacity, a plateau region may occur in which the open circuit voltage is stable in a wide range of the remaining capacity. In the plateau region, since change of the open circuit voltage with change of the remaining capacity is small, it may be difficult to calculate the remaining capacity with high accuracy based on the open circuit voltage. In addition, when charge/discharge currents of the cell 21 are integrated to calculate a remaining capacity, since integrated errors are accumulated as a current integrating period is prolonged, it may be difficult to calculate the remaining capacity with high accuracy based on the integrated current value. In the present embodiment, a lithium-ion storage cell is used as the cell 21. In the lithium-ion storage cell, lithium iron phosphate may be used for a positive-electrode active material thereof, and graphite may be used for a negative-electrode active material thereof. In this case, existence of the plateau region in the correlation between the open circuit voltage and the remaining capacity of the cell 21 becomes remarkable, whereby there is a concern that calculating the remaining capacity of the cell 21 with high accuracy becomes difficult.

In view of the above point, in the present embodiment, the calculation unit 33 calculates a capacity region that is likely to include the remaining capacity of each of the cells 21 configuring the assembled battery 20 and specifies the range of the capacity region, thereby improving accuracy in calculating the remaining capacity. Hereinafter, a method of calculating the capacity region of the cell 21 will be described.

At the timing at which an open circuit voltage of the cell 21 is detected, the calculation unit 33 uses a plurality of predetermined correlations as correlations between the open circuit voltage and the remaining capacity of the cell 21 to calculate, for the correlations, a plurality of reference remaining capacities corresponding to the open circuit voltage of the cell 21, and calculate a region including the reference remaining capacities as a first capacity region A. In the present embodiment, as illustrated in FIG. 2, the calculation unit 33 previously determines a charging property M1 indicating a correlation between the open circuit voltage and the remaining capacity of the cell 21 during charging and a discharging property M2 indicating a correlation between the open circuit voltage and the remaining capacity of the cell 21 during discharging, and calculates the reference remaining capacities using the charging property M1 and the discharging property M2. The calculation unit 33 sets the reference remaining capacity corresponding to a detection value Vr of the open circuit voltage of the cell 21 in the charging property M1 as a minimum remaining capacity A_min in the first capacity region A and sets the reference remaining capacity corresponding to a detection value Vr of the open circuit voltage of the cell 21 in the discharging property M2 as a maximum remaining capacity A_max in the first capacity region A. In this case, the calculation unit 33 calculates, as the first capacity region A, a region defined by the maximum remaining capacity A_max and the minimum remaining capacity A_min. It is noted that the calculation unit 33 may use, as the detection value Vr of the open circuit voltage of the cell 21, a value calculated based on the detection value of the voltage detection unit 31.

The charging property M1 and the discharging property M2 of the cell 21 are previously specified based on the open circuit voltage measured as below, for example, before factory shipment, and are stored in a storage unit included in the BMU 30. Every time the cell 21 is discharged by a predetermined capacity, the open circuit voltage specifying the discharging property M2 is measured after a predetermined quiescent period has elapsed from stop of the discharge. The measurement of the open circuit voltage specifying the discharging property M2 is repeatedly performed until the open circuit voltage of the cell 21 falls below a lower limit voltage from a fully charged state in which the open circuit voltage of the cell 21 is an upper limit voltage or higher. Every time the cell 21 is discharged by a predetermined capacity, the open circuit voltage defining the charging property M1 is measured after a predetermined quiescent period has elapsed from the stop of the charge. The measurement of the open circuit voltage defining the charging property M1 is repeatedly performed until the cell 21 becomes a fully charged state from a state in which the open circuit voltage of the cell 21 has fallen below the lower limit voltage. It is noted that, from the viewpoint of noise reduction, charge and discharge of the cell 21 may be performed at low current.

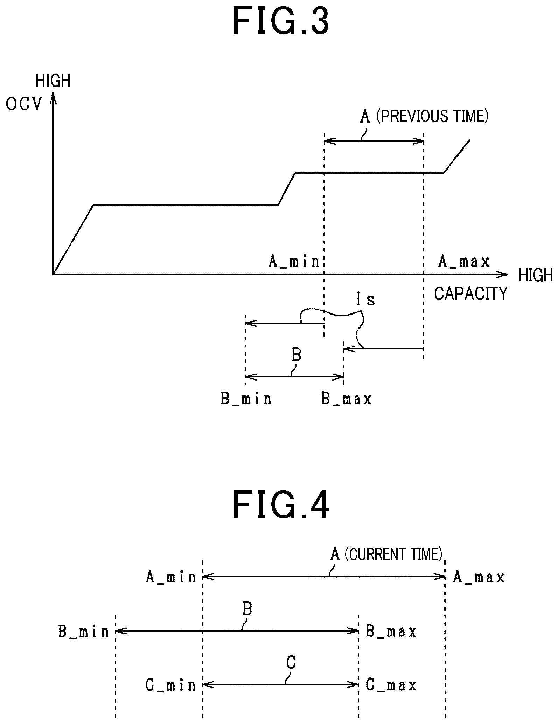

To the maximum remaining capacity and the minimum remaining capacity in a past capacity region calculated at the detection timing of the open circuit voltage before the present time, the calculation unit 33 adds change of the current capacity due to charge and discharge of the cell 21 from the time at which the past capacity region was calculated, to calculate a second capacity region B. FIG. 3 illustrates an example in which the first capacity region A calculated at the previous detection timing of the open circuit voltage is used as the past capacity region to calculate the second capacity region B. To the maximum remaining capacitiy A_max in the previous first capacity region A, the calculation unit 33 adds an integrated value IS of the current capacities from the time at which the first capacity region A was calculated, to calculate a maximum remaining capacitiy B_max in the second capacity region B. To the minimum remaining capacitiy A_min in the previous first capacity region A, the calculation unit 33 adds an integrated value IS of the current capacities from the time at which the first capacity region A was calculated, to calculate a minimum remaining capacitiy B_min in the second capacity region B. It is noted that, in the present embodiment, if the integrated value IS of the current capacities is a positive value, the remaining capacities A_max and B_min sift to the charge side. If the integrated value IS of the current capacities is a negative value, the remaining capacities A_max and B_min sift to the discharge side.

At the detection timing of the open circuit voltage of the cell 21, the calculation unit 33 calculates a third capacity region C based on the current first capacity region A and the current second capacity region B. Herein, in the calculation of the third capacity region C, the calculation unit 33 may set the remaining capacity between the maximum remaining capacity A_max in the first capacity region A and the maximum remaining capacity B_max in the second capacity region B as a maximum remaining capacity C_max in the third capacity region C and set the remaining capacity between the minimum remaining capacity A_min in the first capacity region A and the minimum remaining capacity B_min in the second capacity region B as a minimum remaining capacity C_min in the third capacity region C. In addition, the calculation unit 33 may set an overlapped region between the first capacity region A and the second capacity region B as the third capacity region C. In this case, for example, in FIG. 4, the calculation unit 33 calculates the maximum remaining capacity B_max in the second capacity region B as the maximum remaining capacity C_max in the third capacity region C and calculates the minimum remaining capacity A_min in the first capacity region A as the minimum remaining capacity C_min in the third capacity region C.

Referring to FIG. 3, an example has been described in which the calculation unit 33 uses the previous first capacity region A to calculate the second capacity region B. However, instead of the previous first capacity region A, the previous third capacity region C may be used as the past capacity region. In this case, to the maximum remaining capacity C_max and the minimum remaining capacity C_min in the third capacity region C calculated at the previous detection timing of the open circuit voltage, the calculation unit 33 may add the integrated value IS of the current capacities from the time at which the third capacity region C was calculated, to calculate the maximum remaining capacity B_max and the minimum remaining capacity B_min in the current second capacity region B.

Calculating the regions A, B, C described above can specify the range of the third capacity region C using the first capacity region A and the second capacity region B calculated using different methods.

The calculation unit 33 calculates a full charging capacity using the third capacity region C of the cell 21. In the present embodiment, the calculation unit 33 determines whether the cell 21 is in a fully charged state. If determining that the cell 21 is in a fully charged state, the calculation unit 33 calculates a full charging capacity. For example, in a state in which the assembled battery 20 is being charged using an external charger, if determining that the terminal voltage of the cell 21 has reached a full charge voltage value, the calculation unit 33 determines that the cell 21 is in a fully charged state. In addition, for example, in a state in which the assembled battery 20 is charged by regenerative power generation by the rotary electric machine 10 and the cell 21 is in a fully charged state, at the timing at which an open circuit voltage of the cell 21 is detected, if determining that the open circuit voltage of the cell 21 is the full charge voltage value or higher, the calculation unit 33 determines that the cell 21 is in a fully charged state.

If determining that the cell 21 is in a fully charged state, the calculation unit 33 calculates a full charging capacity region of the cell 21 based on the previous third capacity region C and change of the current capacity due to charge and discharge of the cell 21 from the time at which the third capacity region C was calculated, and calculates a full charging capacity using the full charging capacity region. Specifically, to the maximum remaining capacity C_max and the minimum remaining capacity C_min in the previous third capacity region C, the calculation unit 33 adds the integrated value IS of the current capacities due to charge and discharge of the cell 21 from the time at which the third capacity region C was calculated, to calculate the maximum value and the minimum value in the full charging capacity region and sets the region defined by the maximum value and the minimum value as the full charging capacity region. The calculation unit 33 calculates a capacity in the full charging capacity region as a full charging capacity of the cell 21. For example, the calculation unit 33 calculates, as the full charging capacity of the cell 21, the maximum value in the full charging capacity region or a value obtained by shifting the maximum value to the discharge side by a predetermined value, the minimum value in the full charging capacity region or a value obtained by shifting the minimum value to the charge side by a predetermined value, or an arithmetical average value or a weighted average value of the maximum value and the minimum value in the full charging capacity region.

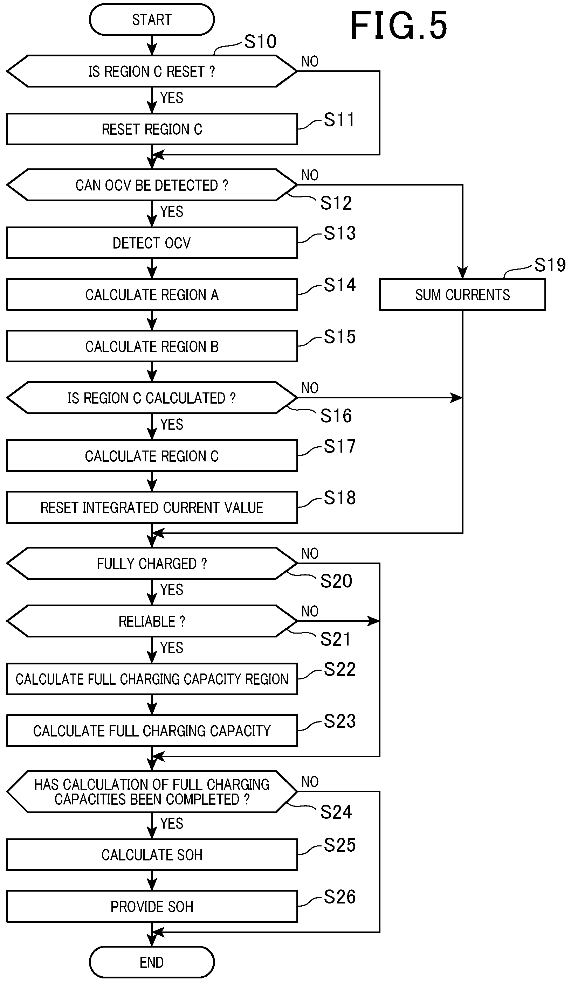

FIG. 5 illustrates a procedure of control in which a method of calculating the first, second, and third capacity regions A, B, C and the full charging capacities described above is applied to calculation of SOH indicating a deterioration state of the assembled battery 20. The control is repeatedly performed by the BMU 30 at predetermined control intervals.

In step S10, it is determined whether a reset condition of the third capacity region C is met. In the present embodiment, it is determined whether a time period in which the third capacity region C is not calculated has continued for a predetermined time period (e.g., several tens of hours or several days) or longer. As the state in which the third capacity region C is not calculated, a state can be considered in which the vehicle is left, and the ignition switch is in an off state for a long time. In addition, if it is determined that the elapsed time from the time at which the previous third capacity region C was calculated cannot be measured due to some troubles, it may be determined that the reset condition of the third capacity region C is met. If an affirmative determination is made in step S10, the process proceeds to step S11. In step S11, the third capacity region C is reset to a predetermined initial region. For example, as the initial region of the third capacity region C, the first capacity region A calculated at the detection timing of the open circuit voltage before the present time may be used. After the processing of step s11, the process proceeds to step s12. In contrast, if a negative determination is made in step S10, the processing of step S11 is not performed, and the process proceeds to step S12. It is noted that the processing of step S10 corresponds to a time period determination unit, and the processing of step s11 corresponds to a reset unit.

In step S12, it is determined whether an open circuit voltage of the cell 21 can be detected. In the present embodiment, it is determined that an open circuit voltage of the cell 21 can be detected before energization of the cell 12 is started when the vehicle starts traveling or is externally charged, and it is determined no open circuit voltage of the cell 21 can be detected in other cases. If a negative determination is made in step S12, the process proceeds to step S19.

In step S19, current capacities due to charge and discharge of the cell 21 from the previous detection timing of the open circuit voltage are integrated to calculate the integrated value IS. The current capacities due to charge and discharge of the cell 21 may be calculated based on detection values of the current sensor 13. After the processing of step S19, the process proceeds to step S20.

In contrast, if an affirmative determination is made in step S12, the process proceeds to step S13. In step S13, an open circuit voltage of the cell 21 is detected. For example, the terminal voltage of the cell 21 after a predetermined time period has elapsed after the cell 21 had become a non-energization state may be assumed as the open circuit voltage, or an open circuit voltage may be estimated from the terminal voltage of the cell 21 in an energization state, to detect an open circuit voltage of the cell 21. As the terminal voltage of the cell 21, a detection value of the voltage detection unit 31 may be used.

In step S14, the first capacity region A is calculated. In the present embodiment, the charging property M1 indicating a correlation between the open circuit voltage and the remaining capacity of the cell 21 during charging and the charging property M2 indicating a correlation between the open circuit voltage and the remaining capacity of the cell 21 during discharging are used to calculate the maximum remaining capacity A_max and the minimum remaining capacity A_min in the first capacity region A based on the detected open circuit voltage of the cell 21. It is noted that when the first capacity region A is calculated, two correlations between the open circuit voltage and the remaining capacity are not necessarily used. For example, one correlation between the open circuit voltage and the remaining capacity of the cell 21 can be used to calculate the first capacity region A. In this case, a detection error of the open circuit voltage may be previously determined, and the detected open circuit voltage may be corrected so as to decrease and increase by the detection error, to calculate two corrected values of the open circuit voltage and calculate the maximum remaining capacity A_max and the minimum remaining capacity A_min in the first capacity region A based on the two corrected values. In addition, for example, three or more correlations between the open circuit voltage and the remaining capacity of the cell 21 may be used to calculate the first capacity region A. It is noted that the processing of step S14 corresponds to a first region calculation unit.

In step S15, the second capacity region B is calculated. In the present embodiment, to the maximum remaining capacitiy and the minimum remaining capacitiy in the third capacity region C at the previous detection timing of the open circuit voltage, the integrated value IS of the current capacities due to charge and discharge of the cell 21 from the time at which the third capacity region C was calculated is added, to calculate the second capacity region B. In the processing of step S15, as the integrated value IS of the current capacities, the value calculated by the processing of step S19 may be used. In the present embodiment, the processing of steps S15, S19 corresponds to a second region calculation unit.

In step S16, it is determined whether to calculate the third capacity region C. For example, if it is determined that the first capacity region A having a range wider than a predetermined range has been calculated, it is determined that specifying the range of the third capacity region C is difficult, whereby it is determined not to calculate the third capacity region C. In addition, for example, if an elapsed time period from the previous detection timing of the open circuit voltage is within a predetermined time period, it is determined that the change from the previous third capacity region C is small, whereby it is determined not to calculate the current third capacity region C. In a case other than the above, it is determined to calculate the third capacity region C. If an affirmative determination is made in step S16, the process proceeds to step S17.

In step S17, the third capacity region C is calculated. In the present embodiment, an overlapped region between the first capacity region A and the second capacity region B calculated by the processing of steps S14, S15 is calculated as the third capacity region C. It is noted that the processing of step s17 corresponds to a third region calculation unit.

It is noted that the regions A to C described above and the integrated value IS of the current capacities calculated by the processing of step S19 may be stored in a memory for backup included in the BMU 30. Hence, the regions A to C and the integrated value IS of the current capacities are stored even after the ignition switch is turned off, whereby the third capacity region C can be calculated over a plurality of trips.

In step S18, the integrated value IS of the current capacities due to charge and discharge of the cell 21 is reset to 0, and the process proceeds to step S20. It is noted that if a negative determination is made in step S16, the processing of steps S17, S18 is not performed, and the process proceeds to step S20.

In step S20, it is determined whether the cell 21 is in a fully charged state. If an affirmative determination is made in step S20, the process proceeds to step S21. In contrast, if a negative determination is made in step S20, the process proceeds to step S24. It is noted that the processing of step S20 corresponds to a full charge determination unit.

In step S21, it is determined whether the full charging capacity is reliable. In the present embodiment, the third capacity region C of the cell 21 is used to calculate a full charging capacity region and calculate a capacity in the full charging capacity region as a full charging capacity. In this case, it can be considered that as the width of the third capacity region C is smaller, accuracy in calculating the full charging capacity is higher, whereby the full charging capacity is more reliable. Hence, the width of the third capacity region C is set as a determination parameter for determining reliability of the full charging capacity. Based on the determination parameter, the reliability of the full charging capacity is determined. Specifically, if the width of the third capacity region C is a predetermined width or smaller, it is determined that accuracy in calculating the full charging capacity is ensured, whereby it is determined that the full charging capacity is reliable. In this case, the process proceeds to step S22. In contrast, if the width of the third capacity region C is the predetermined width or larger, it is determined that accuracy in calculating the full charging capacity is not ensured, whereby it is determined that the full charging capacity is not reliable. In this case, the process proceeds to step S24. It is noted that the processing of step S21 corresponds to a reliability determination unit.

In step S22, a full charging capacity region FCC of the cell 21 is calculated. Herein, to the maximum remaining capacitiy C_max and the minimum remaining capacity C_min in the third capacity region C, the integrated value IS of the current capacities due to charge and discharge of the cell 21 from the time at which the third capacity region C was calculated is added, to calculate the maximum value and the minimum value of the full charging capacity region FCC, and a region defined by the maximum value and the minimum value is set as the full charging capacity region FCC. As the integrated value IS of the current capacities, a value calculated by the processing of step S19 may be used. In step S23, the capacity in the full charging capacity region FCC is calculated as the full charging capacity of the cell 21. It is noted that the processing of steps S23, S23 corresponds to a full charging capacity calculation unit.

In step S24, it is determined whether the calculation of the full charging capacities of the cells 20 configuring the assembled battery 20 has been completed. If the full charging capacities of the cells 20 have been calculated, the process proceeds to step S25. In contrast, if there is a cell whose full charging capacity has not been calculated among the cells 21 configuring the assembled battery 20, the present control is terminated.

In step S25, SOH of the assembled battery 20 is calculated. SOH [%] of the assembled battery 20 is expressed by (the current full charging capacity of the assembled battery 20 / a reference full charging capacity of the assembled battery 20) * 100. The reference full charging capacity of the assembled battery 20 indicates a capacity that can be charged from assembled battery 20, for example, a capacity specified when the assembled battery 20 is designed or when a vehicle test is performed. The current full charging capacity of the assembled battery 20 is, for example, a product of the minimum full charging capacity of the cells 21 configuring the assembled battery 20, the number of the cells of the assembled battery 20 connected in series, and a specified voltage. The specified voltage may be an average voltage at which the assembled battery 20 is discharged and may be specified when the vehicle is designed. It is noted that, considering variation of the remaining capacities of the cells 21 and deterioration of the assembled battery 20, the current full charging capacity of the assembled battery 20 may be corrected.

In step S26, the calculated SOH of the assembled battery 20 is provided to another device. In this case, it can be considered that, for example, the SOH of the assembled battery 20 is displayed on an instrument panel of the vehicle or a car navigation system of the vehicle, or a server outside the vehicle or a mobile device such as a smartphone is notified of the SOH of the assembled battery 20.

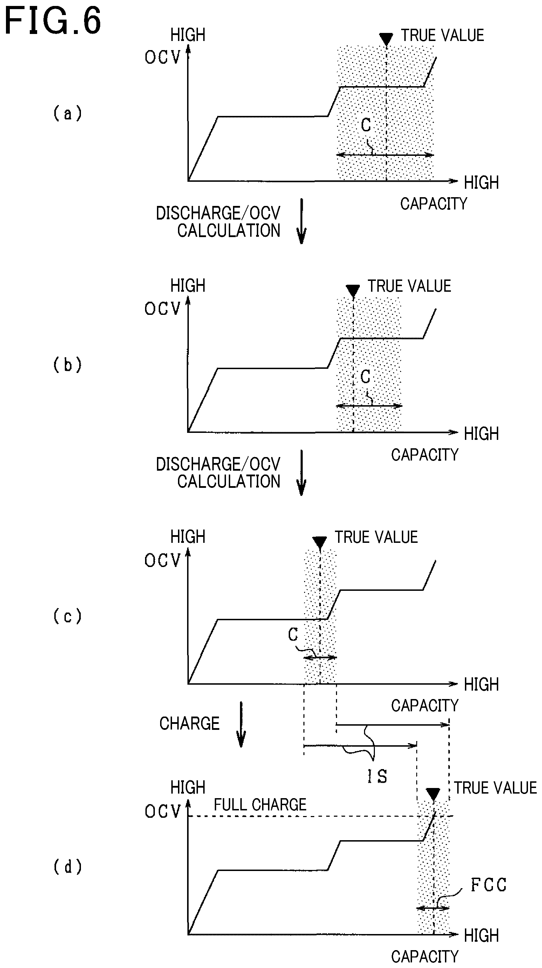

FIG. 6 illustrates an example of control for calculating the third capacity region C and the full charging capacity region FCC. In FIG. 6, discharge of the assembled battery 20 and detection of an open circuit voltage are performed in order of (a), (b), (c). In (d), charge of the assembled battery 20 is performed from the state of (c) to the fully charged state.

In FIG. 6 (a), an initial region is set as the third capacity region C of the cell 21. In this case, there is a concern that, for example, the width of the third capacity region C is wider than that of the plateau region in the correlation between the open circuit voltage and the remaining capacity of the cell 21, whereby accuracy in calculating the remaining capacity is low. In FIG. 6 (b), as an overlapped region between the first capacity region A and the second capacity region B calculated using different methods, the third capacity region C is calculated. Hence, the range of the third capacity region C can be specified accurately. In FIG. 6, the range of the third capacity region C in (b) is specified more accurately than that in (a).

In the present embodiment, the current second capacity region B is calculated using the third capacity region C at the previous detection timing of the current open circuit voltage of the cell 21, and the current third capacity region C is calculated based on the current first and second capacity regions A, B. Hence, since the previous third capacity region C is taken over to the calculation of the current third capacity region C, the range of the current third capacity region C can be specified accurately. Hence, in FIG. 6, the range of the third capacity region C in (c) is specified more accurately than that in (b). Then, the width of the third capacity region C in FIG. 6 (c) is the predetermined width or smaller, whereby it is determined that the full charging capacity is reliable. Hence, the calculation of the full charging capacity region FCC is permitted.

In FIG. 6 (d), to the maximum remaining capacitiy C_max and the minimum remaining capacitiy C_min of the third capacity region C in FIG. 6 (c), the integrated value IS of the current capacities obtained by charging the cell 21 from the time at which the third capacity region C was calculated is added, to calculate the full charging capacity region FCC. In this case, the range of the full charging capacity region FCC is specified, whereby accuracy in calculating the full charging capacity can be improved.

According to the present embodiment described above in detail, the following effects can be obtained.

At the detection timing of the open circuit voltage of the cell 21, the reference remaining capacity of the cell 21 is calculated based on the correlation between the open circuit voltage and the remaining capacity of the cell 21, and the first capacity region A is calculated as a predetermined region including the reference remaining capacity. In addition, to the maximum remaining capacity and the minimum remaining capacity in a past capacity region calculated at the detection timing of the open circuit voltage of the cell 21 before the present time, a change of capacity, which is a change of the current capacity due to charge and discharge of the cell 21 from the time at which the past capacity region was calculated is added, to calculate the second capacity region B. In this case, the first capacity region A is calculated considering variation of the remaining capacities occurring under a condition for detecting the open circuit voltage of the cell 21 and a condition for charging and discharging the cell 21, the second capacity region B is calculated considering integrated errors of the integrated value IS of the current capacities, and a region including an overlapped region between the capacity regions A and B is calculated as the third capacity region C. Hence, the range of the third capacity region C including an actual remaining capacity of the cell 21 can be specified. Since the range of the third capacity region C is specified, accuracy in calculating the remaining capacity of the cell 21 can be improved.

Since the first capacity region A is calculated using a plurality of correlations between the open circuit voltage and the remaining capacity, the first capacity region A can be appropriately calculated while it is assumed that there is variation of charge and discharge properties in the actual cell 21. Instead of the above, a plurality of correlations of the cell 21 having different degrees of deterioration may be used. Alternatively, a plurality of correlations defined within a range of tolerance in the cell 21 may be used.

The width of the third capacity region C is used as a determination parameter for determining reliability of a full charging capacity, and the reliability of the full charging capacity is determined based on the determination parameter. If it is determined that the full charging capacity is reliable, calculation of the full charging capacity is permitted. Hence, in a state in which accuracy in calculating a full charging capacity is high, the full charging capacity of the cell 21 can be calculated.

When the time period in which calculation of the third capacity region C is not performed has continued for a long time, it can be considered that the reliability of the third capacity region C, which has previously been calculated, is lowered. Hence, according to the present embodiment, if it is determined the time period in which calculation of the third capacity region C is not performed has continued for a predetermined period or more, the third capacity region C is reset to a predetermined initial region. Hence, calculation of the second capacity region B can be prevented from being performed using the third capacity region C having low reliability.

<Modifications of first embodiment>

The above first embodiment may be modified as below.

The calculation unit 33 may add the integrated value IS of the current capacities that are corrected so as to decrease by the detection error of the current capacity, to the minimum remaining capacity in the past capacity region (e.g., previous third capacity region C), and add the integrated value IS of the current capacities that are corrected so as to increase by the detection error of the current capacity, to the maximum remaining capacity in the past capacity region, to calculate the second capacity region B. Specifically, in step S19 in FIG. 5 described above, the integrated value IS1 of the current capacities that are corrected so as to decrease by the detection error of the current capacity and the integrated value IS2 of the current capacities that are corrected so as to increase by the detection error of the current capacity may be calculated. For example, the integrated value IS1 corrected so as to decrease by the detection error may be calculated by the following expression (A), and the integrated value IS2 corrected so as to increase by the detection error may be calculated by the following expression (B). It is noted that the detection error of the current capacity may be previously determined.

IS1(current value) = IS1(previous value) + (current capacity - detection error)          (Expression A)

IS2(current value) = IS2(previous value) + (current capacity + detection error)          (Expression B)

In this case, in step S15, the integrated value IS1 may be added to the minimum remaining capacity in the past capacity region, and the integrated value IS2 may be added to the maximum remaining capacity in the past capacity region, to calculate the second capacity region B.

According to the above configuration, a small amount of the minimum remaining capacity in the past capacity region is added considering a detection error of the current capacity. In contrast, a large amount of the maximum remaining capacity in the past capacity region is added considering a detection error of the current capacity. Hence, considering that a sensor error and the like are included in a detection value of the current capacity, the second capacity region B can be appropriately calculated.

It is noted that, in step S22, the integrated value IS1 corrected so as to decrease by the detection error may be added to the minimum remaining capacity C_min in the third capacity region C, and the integrated value IS2 corrected so as to increase by the detection error may be added to the maximum remaining capacity C_max in the third capacity region C, to calculate the full charging capacity region FCC.

Instead of calculating the second capacity region B at the detection timing pf the open circuit voltage of the cell 21, the calculation unit 33 may update the second capacity region B in the processing of step S19 in FIG. 5 described above as needed. In this case, the processing of step S15 may not be performed. It is noted that the integrated value IS of the current capacities calculated in the processing of step S19 may be used for calculating the full charging capacity region FCC.

In the processing of step S17 in FIG. 5 described above, the minimum remaining capacity C_min in the third capacity region C may be calculated by the following expression (C), and the maximum remaining capacity C_max in the third capacity region C may be calculated by the following expression (D).

$$C\_min = (\alpha*A\_min + \beta*B\_min) / (\alpha + \beta) \qquad \text{(Expression C)}$$

$$C\_max = (\gamma*A\_max + \varepsilon*B\_max) / (\gamma + \varepsilon) \qquad \text{(Expression D)}$$

In the above, $\alpha, \beta, \gamma, \varepsilon$ are weighting coefficients. The coefficients $\alpha, \beta, \gamma, \varepsilon$ may be set to fixed values (specifically, $\alpha = \beta = \gamma = \varepsilon = 1$) or may be variably set depending on the remaining capacity of the cell 21. For example, when the remaining capacity of the cell 21 (specifically, the remaining capacities A_min, A_max, B_min, B_max) is small, rates of the coefficients $\beta, \varepsilon$ in the second capacity region B with respect to the coefficients $\alpha, \gamma$ in the first capacity region A (in other words, a coefficient ratios $\beta/\alpha, \varepsilon/\gamma$) may be set to be larger than those in a case in which the remaining capacity of the cell 21 is large. In this case, in a state in which the second capacity region B is reflected more than the first capacity region A, the third capacity region C is calculated. In addition, the BMU 30 may detect a temperature of the assembled battery 20 to variably set the coefficients $\alpha, \beta, \gamma, \varepsilon$ depending on the temperature of the assembled battery 20.

In the processing of step S21 in the FIG. 5 described above, the determination parameter may be other than the width of the third capacity region C. For example, the difference between the third capacity region C and the second capacity region B at the time at which the third capacity region C is calculated may be set as a determination parameter, and it may be determined whether the full charging capacity is reliable based on the determination parameter. In this case, for example, if the following expressions (E), (F), and (G) are met, it may be determined that the full charging capacity is reliable.

$$C\_min - B\_min \geq \text{predetermined amount} \qquad \text{(Expression E)}$$

$$B\_max - C\_max \geq \text{predetermined amount} \qquad \text{(Expression F)}$$

$$(C\_min - B\_min) + (B\_max - C\_max) \geq \text{predetermined amount}$$
$$\text{(Expression G)}$$

In the above, the left-hand sides of the expressions (E), (F), and (G) are limitation degrees indicating degrees of the limitation of the range of the third capacity region C with respect to that of the second capacity region B. If the limitation degree is the predetermined amount or higher, it is determined that accuracy in calculating the full charging capacity is ensured, whereby it is determined that the full charging capacity is reliable. In contrast, if the limitation degree is lower than the predetermined amount, it is determined that accuracy in calculating the full charging capacity is not ensured, whereby it is determined that the full charging capacity is not reliable. As the limitation degree, instead of the second capacity region B, a value indicating a degree of the limitation of the third capacity region C with respect to the first capacity region A may be calculated. In addition, integrated values of the left-hand sides of the expressions (E), (F), and (G) may be calculated to determine whether the full charging capacity is reliable based on whether the integrated values are a predetermined amount or higher.

In addition, for example, at least one of the width of the full charging capacity region, the maximum capacity value in the full charging capacity region, and the minimum capacity value in the full charging capacity region may be set as a determination parameter to determine whether the full charging capacity is reliable based on the determination parameter. In this case, after the processing of step S20, before the processing of step S21, the processing of step S22 may be performed. Specifically, if the width of the full charging capacity region is a predetermined width or less, it is determined that the full charging capacity is reliable. If the width of the full charging capacity region is wider than the predetermined width, it is determined that the full charging capacity is not reliable. If the maximum capacity value in the full charging capacity region is a first predetermined value or smaller, it is determined that the full charging capacity is reliable. If the maximum capacity value in the full charging capacity region is larger than the first predetermined value, it is determined that the full charging capacity is not reliable. If the minimum capacity value of the full charging capacity region is a second predetermined value or larger, it is determined that the full charging capacity is reliable. If the minimum capacity value in the full charging capacity region is smaller than the second predetermined value, it is determined that the full charging capacity is not reliable. It is noted that the first predetermined value is larger than the second predetermined value.

In FIG. 5 described above, processing of steps S10, S11, S16 may not be performed.

In FIG. 5 described above, instead of the processing of steps S25, S26, another process may be performed. For example, if an affirmative determination is made in step S24, SOC of the assembled battery 20 may be calculated. The SOC [%] of the assembled battery 20 is expressed by (current remaining capacity of the assembled battery 20 / current full charging capacity of the assembled battery 20) * 100. As the current full charging capacity of the assembled battery 20, the full charging capacities of the cells 21 calculated by the processing of step S23 may be used. The current remaining capacity of the assembled battery 20 may be calculated based on the third capacity regions C of the cells calculated by the processing of step S17. In addition, the processing of steps S24 to S26 may not be performed.

After the processing of step S17 in FIG. 5 described above, processing of using the third capacity region C to calculate the remaining capacities of the respective cells 21 may be used. In this case, for example, the calculation unit 33 may calculate, as the remaining capacity of the cell 21, the maximum remaining capacity $C\_max$ in the third capacity region C or a value obtained by shifting the maximum remaining capacity $C\_max$ to the discharge side by a predetermined value, the minimum remaining capacity $C\_min$ in the third capacity region C or a value obtained by shifting the minimum remaining capacity $C\_min$ to the charge side by a predetermined value, or an arithmetical average value or a weighted average value of the maximum remaining capacity $C\_max$ and the minimum remaining capacity $C\_min$ in the third capacity region C. In addition, after the processing of step S17 in FIG. 5 described above, the third capacity region C may be used to set the maximum electrical power that can be input to or output from the assembled battery 20 (i.e., Win, Wout). When the third capacity region C is used to calculate a remaining capacity of each of the cells or set the maximum electrical power that can be input to or output from the assembled battery 20, the processing of steps S20 to S26 may not be performed.

<Second embodiment>

Hereinafter, the second embodiment will be described with reference to the drawings focusing on differences from the first embodiment described above. In the present embodiment, a full charging capacity is calculated at the detection timing of an open circuit voltage of the cell 21 instead of the timing at which it is determined that the cell 21 is in a fully charged state.

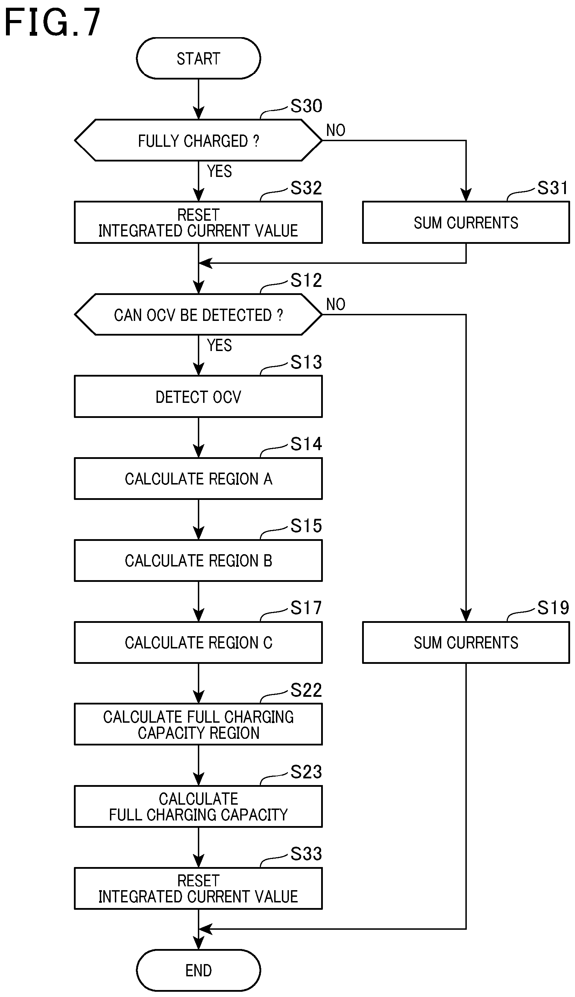

FIG. 7 illustrates a procedure of control for calculating a full charging capacity. The control is repeatedly performed by the BMU 30 at predetermined control intervals. It is noted, in FIG. 7, the same processing as the processing illustrated in FIG. 5 described above is denoted by the same reference sign for the sake of convenience.

In step s30, it is determined whether the cell 21 is in a fully charged state. In the present embodiment, a state is assumed in which the assembled battery 20 is being charged using an external charger, and if it is determined that the terminal voltage of the cell 21 has reached a full charging voltage value, it is determined that the cell 21 is in a fully charged state. If a negative determination is made in step S30, the process proceeds to step S31. If an affirmative determination is made in step S32, the process proceeds to step S32.

In step S31, current capacities due to charge and discharge of the cell 21 from the timing at which it is determined that the cell 21 is in a fully charged state are added to calculate the integrated value IS. The current capacities due to charge and discharge of the cell 21 may be calculated based on detection values of the current sensor 13. In step S32, the integrated value IS of the current capacities calculated in the processing of step S31 is reset to 0. After the processing of steps S31, S32, the process proceeds to step S12.

The processing of steps S12 to S17, S19 is similar to that of the first embodiment. After the processing of step S17, the process proceeds to step S22. The processing of steps S22, S23 is similar to that of the first embodiment. It is noted that, in FIG. 7, the processing of step S16 is omitted. In the present embodiment, the processing of step S31 corresponds to an integrated value calculation unit, and the processing of steps S22, S23 corresponds to a full charging capacity calculation unit.

After the processing of step S23, the process proceeds to step S33. In step S33, the integrated value IS of current capacities calculated in the processing of step S19 is reset to 0. It is noted that the integrated value IS of current capacities calculated in the processing of step S19 is the integrated value IS of current capacities due to charge and discharge of the cell 21 from the previous detection timing of the open circuit voltage. After the processing of step S33, the present control is terminated.

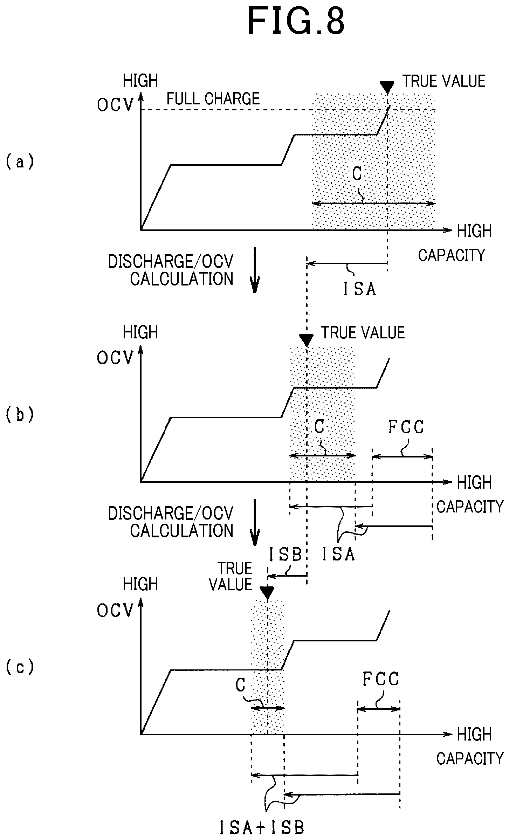

FIG. 8 illustrates an example in which the third capacity region C and the full charging capacity region FCC are calculated. In FIG. 8, discharge of the assembled battery 20 and detection of an open circuit voltage are performed in order of (a), (b), (c).

In FIG. 8 (a), the third capacity region C in a case in which the cell 21 is in a fully charged state is set. The third capacity region C in a case in which the cell 21 is in a fully charged state may be a previously set initial setting region.

In FIG. 8 (b), (c), the current first capacity region A and the second capacity region B are used to update the third capacity region C, and the third capacity region C is used to calculate the full charging capacity region FCC.

In FIG. 8 (b), in the calculation of the second capacity region B, to the maximum remaining capacity C_max and the minimum remaining capacity C_min in the third capacity region C, which is a setting region, an integrated value ISA of the current capacities due to charge and discharge of the cell 21 in a time period from the timing in FIG. 8 (a) to the timing in (b) is added. In addition, in the calculation of the full charging capacity region FCC, to the maximum remaining capacity C_max and the minimum remaining capacity C_min in the third capacity region C at the timing in FIG. 8 (b), the integrated value ISA of the current capacities due to charge and discharge of the cell 21 in a time period from the timing in FIG. 8 (a) to the timing in (b) is added.

In FIG. 8 (c), in the calculation of the second capacity region B, to the maximum remaining capacity C_max and the minimum remaining capacity C_min in the third capacity region C in FIG. 8 (b), an integrated value ISB of the current capacities due to charge and discharge of the cell 21 in a time period from the timing in FIG. 8 (b) to the timing in (c) is added. Herein, the integrated value ISB of the current capacities calculated in the processing of step S19 in FIG. 7 described above may be used. In the calculation of the full charging capacity region FCC, to the maximum remaining capacity C_max and the minimum remaining capacity C_min in the third capacity region C in FIG. 8 (c), an integrated value ISA+ISB of the current capacities due to charge and discharge of the cell 21 in a time period from the timing in FIG. 8 (a) to the timing in FIG. 8 (c) is added. Herein, the integrated value ISA+ISB of the current capacities calculated in the processing of step S31 in FIG. 7 described above may be used.

According to the above configuration, the full charging capacity of the cell 21 can be calculated at each timing at which an open circuit voltage of the cell 21 is detected.

It is noted that after the processing of step S33 in FIG. 7, as in the first embodiment, the processing of calculating SOH and SOC of the assembled battery 20 may be performed. In addition, after the processing of step S17 in FIG. 7, as in the first embodiment, the third capacity region C may be used to calculate a remaining capacity of each of the cells 21 or set the maximum electrical power that can be input to or output from the assembled battery 20.

<Other embodiments>

It is noted that the above embodiments may be modified as below.

The calculation unit 33 may calculate SOH of the cell 21 using the third capacity region C instead of the full charging capacity. In this case, in the processing of step S23 in FIG. 5 described above, a capacity in the full charging capacity region FCC may be calculated as the full charging capacity of the cell 21, and the full charging capacity may be divided by the reference full charging capacity of the cell 21 to calculate SOC of the cell 21. The reference full charging capacity of the cell 21 is a capacity specified when the cell 21 is designed or when a vehicle test is performed.

In the present embodiment, although a battery system for a vehicle has been described, the battery system may be for a movable body other than the vehicle, for example, an aerial vehicle, or a boat. In addition, the battery system may not be for a movable body but may be stationary. Specifically, the battery system can be provided so as to be attached to a building such as a house, a store, or a public facility.

The vehicle control device and the processing thereof described in the present disclosure may be implemented by a dedicated computer that is provided by configuring a processor and a memory that are programmed to execute one or more functions embodied by a computer program. Alternatively, the vehicle control device and the processing thereof described in the present disclosure may be implemented by a dedicated computer that is provided by configuring a processor with one or more dedicated hardware logic circuits. Alternatively, the vehicle control device and the processing thereof described in the present disclosure may be implemented by one or more dedicated computers that are configured by combining a processor and a memory that are programmed to execute one or more functions, with a processor that is configured by one or more hardware logic circuits. Furthermore, the computer program may be stored in a computer readable non-transitory tangible storage medium, as instructions to be executed by a computer.

Hereinafter, characteristic configurations extracted from the embodiments described above will be described.

[Configuration 1]

A remaining capacity calculation device (30) that calculates a remaining capacity of a storage cell (21) when the storage cell is charged and discharged, the device including:

a first region calculation unit that calculates, at a detection timing of an open circuit voltage of the storage cell, a reference remaining capacity of the storage cell based on a correlation between the open circuit voltage and the remaining capacity of the storage cell, and calculates, as a first capacity region, a predetermined region including the reference remaining capacity;

a second region calculation unit that calculates a second capacity region by, to a maximum remaining capacity and a minimum remaining capacity in a past capacity region calculated at the detection timing before a present time, adding a change of capacity, which is a change of a current capacity due to charge and discharge of the storage cell from time at which the past capacity region was calculated; and

a third region calculation unit that calculates, at the detection timing, a region including an overlapped region between the first capacity region and the second capacity region, as a third capacity region including an actual remaining capacity.

[Configuration 2]

The remaining capacity calculation device according to configuration 1, wherein

at the detection timing, the first region calculation unit uses a plurality of correlations specified as the correlation to calculate, for the correlations, a plurality of reference remaining capacities corresponding to the open circuit voltage and calculate, as the first capacity region, a region including the reference remaining capacities.

[Configuration 3]

The remaining capacity calculation device according to configuration 1 or 2, wherein

the second region calculation unit sets, as the past capacity region, the third capacity region calculated by the third region calculation unit before the present time, and adds the change of capacity due to charge and discharge of the storage cell from time at which the third capacity region was calculated, to a maximum remaining capacity and a minimum remaining capacity of the third capacity region, to calculate the second capacity region.

[Configuration 4]

The remaining capacity calculation device according to any one of configurations 1 to 3, wherein

in the calculation of the third capacity region, the third region calculation unit sets, as a maximum remaining capacity in the third capacity region, the remaining capacity between a maximum remaining capacity in the first capacity region and a maximum remaining capacity in the second capacity region, and sets, as a minimum remaining capacity in the third capacity region, the remaining capacity between a minimum remaining capacity in the first capacity region and a minimum remaining capacity in the second capacity region.

[Configuration 5]

The remaining capacity calculation device according to any one of configurations 1 to 3, wherein

the third region calculation unit sets, as the third capacity region, an overlapped region between the first capacity region and the second capacity region.

[Configuration 6]

The remaining capacity calculation device according to any one of configurations 1 to 5, wherein

the second region calculation unit adds the change of capacity that is corrected so as to decrease by a detection error of the current capacity, to the minimum remaining capacity in the past capacity region, and add the change of capacity that is corrected so as to increase by the detection error of the current capacity, to the maximum remaining capacity in the past capacity region, to calculate the second capacity region.

[Configuration 7]

The remaining capacity calculation device according to any one of configurations 1 to 6, further including:

a full charge determination unit that determines whether the storage cell is in a fully charged state; and

a full charging capacity calculation unit that, if it is determined that the storage cell is in the fully charged state, calculates a full charging capacity region of the storage cell based on the third capacity region calculated at previous detection timing and the change of the current capacity due to charge and discharge of the storage cell from time at which the third capacity region was calculated, and calculates a full charging capacity based on the full charging capacity region.

[Configuration 8]

The remaining capacity calculation device according to any one of configurations 1 to 6, further including:

an integrated value calculation unit that calculates, as an integrated capacity value, an integrated value of current capacities due to charge and discharge of the storage cell from time at which the storage cell is fully charged; and a full charging capacity calculation unit that, at the detection timing, calculates a full charging capacity region of the storage cell based on the third capacity region calculated by the third region calculation unit and the integrated capacity value calculated by the integrated value calculation unit, and calculates a full charging capacity based on the full charging capacity region.

[Configuration 9]

The remaining capacity calculation device according to configuration 7 or 8, further including:

a reliability determination region that sets, as a determination parameter, at least any of a width of the third capacity region calculated by the third region calculation unit, a width of the full charging capacity region calculated by the full charging capacity calculation unit, a maximum capacity value or a minimum capacity value in the full charging capacity region, a difference between the third capacity region and the first capacity region at time at which the third capacity region is calculated, and a difference between the third capacity region and the second capacity region at the time at which the third capacity region is calculated, and determines reliability of the full charging capacity calculated by the full charging capacity region based on the determination parameter; and a permission unit that permits the calculation of the full charging capacity by the full charging capacity calculation unit when the reliability determination region determines the full charging capacity to be reliable.

[Configuration 10]

The remaining capacity calculation device according to any one of configurations 1 to 9, further including:

a time period determination unit that determines whether a time period in which the third capacity region is not calculated has continued for a predetermined time period or longer; and a reset unit that resets the third capacity region when it is determined that the time period in which the third capacity region is not calculated has continued for the predetermined time period or longer.

The present disclosure has so far been described based on embodiments. However, the present disclosure should not be construed as being limited to these embodiments or the structures. The present disclosure should encompass various modifications, and modifications within the range of equivalence. In addition, various combinations and modes, as well as other combinations and modes, including those which include one or more additional elements, or those which include fewer elements should be construed as being within the scope and spirit of the present disclosure.

## Claims

1. A remaining capacity calculation device (30) that calculates a remaining capacity of a storage cell (21) when the storage cell is charged and discharged, the device comprising:

a first region calculation unit that calculates, at a detection timing of an open circuit voltage of the storage cell, a reference remaining capacity of the storage cell based on a correlation between the open circuit voltage and the remaining capacity of the storage cell, and calculates, as a first capacity region, a predetermined region including the reference remaining capacity;
a second region calculation unit that calculates a second capacity region by, to a maximum remaining capacity and a minimum remaining capacity in a past capacity region calculated at the detection timing before a present time, adding a change of capacity, which is a change of a current capacity due to charge and discharge of the storage cell from time at which the past capacity region was calculated; and
a third region calculation unit that calculates, at the detection timing, a region including an overlapped region between the first capacity region and the second capacity region, as a third capacity region including an actual remaining capacity.

2. The remaining capacity calculation device according to claim 1, wherein
at the detection timing, the first region calculation unit uses a plurality of correlations specified as the correlation to calculate, for the correlations, a plurality of reference remaining capacities corresponding to the open circuit voltage and calculate, as the first capacity region, a region including the reference remaining capacities.

3. The remaining capacity calculation device according to claim 1, wherein
the second region calculation unit sets, as the past capacity region, the third capacity region calculated by the third region calculation unit before the present time, and adds the change of capacity due to charge and discharge of the storage cell from time at which the third capacity region was calculated, to a maximum remaining capacity and a minimum remaining capacity of the third capacity region, to calculate the second capacity region.

4. The remaining capacity calculation device according to claim 1, wherein
in the calculation of the third capacity region, the third region calculation unit sets, as a maximum remaining capacity in the third capacity region, the remaining capacity between a maximum remaining capacity in the first capacity region and a maximum remaining capacity in the second capacity region, and sets, as a minimum remaining capacity in the third capacity region, the remaining capacity between a minimum remaining capacity in the first capacity region and a minimum remaining capacity in the second capacity region.

5. The remaining capacity calculation device according to claim 1, wherein
the third region calculation unit sets, as the third capacity region, an overlapped region between the first capacity region and the second capacity region.

6. The remaining capacity calculation device according to claim 1, wherein
the second region calculation unit adds the change of capacity that is corrected so as to decrease by a detection error of the current capacity, to the minimum remaining capacity in the past capacity region, and add the change of capacity that is corrected so as to increase by the detection error of the current capacity, to the maximum remaining capacity in the past capacity region, to calculate the second capacity region.

7. The remaining capacity calculation device according to claim 1, further comprising:

a full charge determination unit that determines whether the storage cell is in a fully charged state; and
a full charging capacity calculation unit that, if it is determined that the storage cell is in the fully charged state, calculates a full charging capacity region of the storage cell based on the third capacity region calculated at previous detection timing and the change of the current capacity due to charge and discharge of the storage cell from time at which the third capacity region was calculated, and calculates a full charging capacity based on the full charging capacity region.

8. The remaining capacity calculation device according to claim 1, further comprising:

an integrated value calculation unit that calculates, as an integrated capacity value, an integrated value of current capacities due to charge and discharge of the storage cell from time at which the storage cell is fully charged; and
a full charging capacity calculation unit that, at the detection timing, calculates a full charging capacity region of the storage cell based on the third capacity region calculated by the third region calculation unit and the integrated capacity value calculated by the integrated value calculation unit, and calculates a full charging capacity based on the full charging capacity region.

9. The remaining capacity calculation device according to claim 7 or 8, further comprising:

a reliability determination region that sets, as a determination parameter, at least any of a width of the third capacity region calculated by the third region calculation unit, a width of the full charging capacity region calculated by the full charging capacity calculation unit, a maximum capacity value or a minimum capacity value in the full charging capacity region, a difference between the third capacity region and the first capacity region at time at which the third capacity region is calculated, and a difference between the third capacity region and the second capacity region at the time at which the third capacity region is calculated, and determines reliability of the full charging capacity calculated by the full charging capacity region based on the determination parameter; and
a permission unit that permits the calculation of the full charging capacity by the full charging capacity calculation unit when the reliability determination region determines the full charging capacity to be reliable.

10. The remaining capacity calculation device according to claim 1, further comprising:

a time period determination unit that determines whether a time period in which the third capacity region is not calculated has continued for a predetermined time period or longer; and
a reset unit that resets the third capacity region when it is determined that the time period in which the third capacity region is not calculated has continued for the predetermined time period or longer.

11. A program that causes a computer (30) to perform a process for calculating a remaining capacity of a storage cell (21) when the storage cell is charged and discharged, the process comprising:

a first region calculation step of calculating, at a detection timing of an open circuit voltage of the storage cell, a reference remaining capacity of the storage cell based on a correlation between the open circuit voltage and the remaining capacity of the storage cell, and calculating, as a first capacity region, a predetermined region including the reference remaining capacity;
a second region calculation step of calculating a second capacity region by, to a maximum remaining capacity and a minimum remaining capacity in a past capacity region calculated at the detection timing before a present time, adding a change of capacity, which is a change of a current capacity due to charge and discharge of the storage cell from time at which the past capacity region was calculated; and
a third region calculation step of calculating, at the detection timing, a region including an overlapped region between the first capacity region and the second capacity region, as a third capacity region including an actual remaining capacity.

# FIG.1

# FIG.2

# FIG.3

# FIG.4

# FIG.5

```
              ┌─────────────┐
              │    START    │
              └──────┬──────┘
                     │                    ┌─S10
          ┌──────────▼──────────┐  NO
         ◄   IS REGION C RESET ? ►────────────┐
          └──────────┬──────────┘             │
                     │ YES                     │
              ┌──────▼──────┐  ┌─S11           │
              │ RESET REGION C│                │
              └──────┬──────┘                  │
                     │◄────────────────────────┘
          ┌──────────▼──────────┐  NO
         ◄  CAN OCV BE DETECTED ? ►─────────────────────┐
          └──────────┬──────────┘   ┌─S12                │
                     │ YES                                │
              ┌──────▼──────┐  ┌─S13                      │
              │  DETECT OCV │                             │
              └──────┬──────┘                             │
                     │                   ┌─S19            │
              ┌──────▼──────┐  ┌─S14   ┌──────▼──────┐    │
              │CALCULATE REGION A│     │ SUM CURRENTS │   │
              └──────┬──────┘         └─────────────┘     │
                     │
              ┌──────▼──────┐  ┌─S15
              │CALCULATE REGION B│
              └──────┬──────┘
          ┌──────────▼──────────┐  NO
         ◄ IS REGION C CALCULATED ? ►──────────────►
          └──────────┬──────────┘   ┌─S16
                     │ YES
              ┌──────▼──────┐  ┌─S17
              │CALCULATE REGION C│
              └──────┬──────┘
              ┌──────▼──────┐  ┌─S18
              │RESET INTEGRATED CURRENT VALUE│
              └──────┬──────┘
                     │◄───────────────────────────
          ┌──────────▼──────────┐  NO
         ◄     FULLY CHARGED ?    ►──────────┐
          └──────────┬──────────┘  ┌─S20      │
                     │ YES                     │
          ┌──────────▼──────────┐  NO          │
         ◄       RELIABLE ?       ►───────►     │
          └──────────┬──────────┘  ┌─S21         │
                     │ YES                        │
              ┌──────▼──────┐  ┌─S22               │
              │CALCULATE FULL CHARGING CAPACITY REGION│
              └──────┬──────┘
              ┌──────▼──────┐  ┌─S23
              │CALCULATE FULL CHARGING CAPACITY│
              └──────┬──────┘
                     │◄──────────────────────
          ┌──────────▼──────────┐  NO
         ◄ HAS CALCULATION OF FULL CHARGING ►────┐
         ◄ CAPACITIES BEEN COMPLETED ?      ►    │
          └──────────┬──────────┘  ┌─S24          │
                     │ YES                         │
              ┌──────▼──────┐  ┌─S25                │
              │ CALCULATE SOH│                      │
              └──────┬──────┘                       │
              ┌──────▼──────┐  ┌─S26                 │
              │  PROVIDE SOH│                        │
              └──────┬──────┘                        │
                     │◄──────────────────────────────┘
              ┌──────▼──────┐
              │     END     │
              └─────────────┘
```

# FIG.6

(a)

DISCHARGE/OCV
CALCULATION

(b)

DISCHARGE/OCV
CALCULATION

(c)

CHARGE

(d)

# FIG.7

```
                    ┌─────────────┐
                    │    START    │
                    └─────────────┘
                           │
                           ▼            S30
              ◁─────────────────────────▷  NO ──────────────┐
                    FULLY CHARGED ?                          │
              ◁─────────────────────────▷                   │
                           │ YES                             ▼
                           ▼            S32          ┌──────────────┐ S31
                    ┌─────────────┐                  │ SUM CURRENTS │
                    │    RESET    │                  └──────────────┘
                    │ INTEGRATED  │                         │
                    │CURRENT VALUE│                         │
                    └─────────────┘                         │
                           │◄───────────────────────────────┘
                           ▼            S12
              ◁─────────────────────────▷  NO ──────────────┐
                  CAN OCV BE DETECTED ?                      │
              ◁─────────────────────────▷                   │
                           │ YES                             │
                           ▼            S13                  │
                    ┌─────────────┐                          │
                    │ DETECT OCV  │                          │
                    └─────────────┘                          │
                           │                                 │
                           ▼            S14                  │
                    ┌─────────────┐                          │
                    │  CALCULATE  │                          │
                    │  REGION A   │                          │
                    └─────────────┘                          │
                           │                                 │
                           ▼            S15                  │
                    ┌─────────────┐                          │
                    │  CALCULATE  │                          │
                    │  REGION B   │                          │
                    └─────────────┘                          │
                           │                                 │
                           ▼            S17                  ▼            S19
                    ┌─────────────┐                  ┌──────────────┐
                    │  CALCULATE  │                  │ SUM CURRENTS │
                    │  REGION C   │                  └──────────────┘
                    └─────────────┘                          │
                           │            S22                  │
                           ▼                                 │
                    ┌─────────────┐                          │
                    │  CALCULATE  │                          │
                    │FULL CHARGING│                          │
                    │CAPACITY REGION                         │
                    └─────────────┘                          │
                           │            S23                  │
                           ▼                                 │
                    ┌─────────────┐                          │
                    │  CALCULATE  │                          │
                    │FULL CHARGING│                          │
                    │  CAPACITY   │                          │
                    └─────────────┘                          │
                           │            S33                  │
                           ▼                                 │
                    ┌─────────────┐                          │
                    │    RESET    │                          │
                    │ INTEGRATED  │                          │
                    │CURRENT VALUE│                          │
                    └─────────────┘                          │
                           │◄───────────────────────────────┘
                           ▼
                    ┌─────────────┐
                    │     END     │
                    └─────────────┘
```

# FIG.8

(a)

DISCHARGE/OCV
CALCULATION

(b)

DISCHARGE/OCV
CALCULATION

(c)

# EP 4 636 420 A1

<table>
<tr><td colspan="2">INTERNATIONAL SEARCH REPORT</td><td>International application No.<br><br>**PCT/JP2023/040731**</td></tr>
</table>

| A. | CLASSIFICATION OF SUBJECT MATTER |
|---|---|

***G01R 31/388***(2019.01)i; ***G01R 31/382***(2019.01)i; ***G01R 31/3828***(2019.01)i; ***G01R 31/387***(2019.01)i; ***G01R 31/392***(2019.01)i; ***H01M 10/48***(2006.01)i; ***H02J 7/00***(2006.01)i
FI: G01R31/388; G01R31/387; G01R31/382; G01R31/3828; G01R31/392; H01M10/48 P; H02J7/00 X

According to International Patent Classification (IPC) or to both national classification and IPC

| B. | FIELDS SEARCHED |
|---|---|

Minimum documentation searched (classification system followed by classification symbols)
G01R31/388; G01R31/382; G01R31/3828; G01R31/387; G01R31/392; H01M10/48; H02J7/00

Documentation searched other than minimum documentation to the extent that such documents are included in the fields searched
Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| X | JP 2017-125813 A (GS YUASA CORP) 20 July 2017 (2017-07-20) paragraphs [0065]-[0075], fig. 5-13 | 1, 5-6, 10-11 |
| A | | 2-4, 7-9 |
| A | JP 2022-518896 A (LG ENERGY SOLUTION, LTD.) 17 March 2022 (2022-03-17) entire text, all drawings | 1-11 |
| A | JP 2013-57537 A (GS YUASA CORP) 28 March 2013 (2013-03-28) entire text, all drawings | 1-11 |
| A | WO 2022/050540 A1 (LG ENERGY SOLUTION, LTD.) 10 March 2022 (2022-03-10) entire text, all drawings | 1-11 |

☐ Further documents are listed in the continuation of Box C.　　☑ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **22 December 2023** | **16 January 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

22

**INTERNATIONAL SEARCH REPORT**
Information on patent family members

International application No.

**PCT/JP2023/040731**

| Patent document cited in search report | | | Publication date (day/month/year) | Patent family member(s) | | | Publication date (day/month/year) |
|---|---|---|---|---|---|---|---|
| JP | 2017-125813 | A | 20 July 2017 | US paragraphs [0096]-[0107], fig. 5-13 WO CN | 2019/0025377 2017/122758 108474824 | A1 A1 A | |
| JP | 2022-518896 | A | 17 March 2022 | US entire text, all drawings WO EP KR CN | 2022/0373610 2021/091236 4040568 10-2021-0053748 114599983 | A1 A1 A1 A A | |
| JP | 2013-57537 | A | 28 March 2013 | (Family: none) | | | |
| WO | 2022/050540 | A1 | 10 March 2022 | EP entire text, all drawings JP KR CN | 4135099 2023-524580 10-2022-0031412 115516695 | A1 A A A | |

Form PCT/ISA/210 (patent family annex) (January 2015)

**REFERENCES CITED IN THE DESCRIPTION**

**Patent documents cited in the description**

- JP 2022198097 A

- JP 2010266221 A